# EUROPÄISCHE PATENTSCHRIFT

(11) **EP 1 186 219 B1**
(45) Veröffentlichungstag und Bekanntmachung des Hinweises auf die Patenterteilung: **15.12.2004**
(21) Anmeldenummer: 00934862.4
(22) Anmeldetag: 03.04.2000
(51) Int. Cl.: H05K 13/04

(54) **VERFAHREN ZUM BESTÜCKEN VON SUBSTRATEN MIT BAUELEMENTEN**
METHOD OF PLACING COMPONENTS ON SUBSTRATES
PROCEDE DE MISE EN PLACE DE COMPOSANTS SUR UN SUBSTRAT

(30) Priorität: 30.04.1999 DE 19919916
(43) Veröffentlichungstag der Anmeldung: 13.03.2002
(73) Patentinhaber: Siemens Aktiengesellschaft, 80333 München (DE)
(72) Erfinder: SCHINDLER, Horst, D-85635 Höhenkirchen-Siegertsbrunn (DE)
(74) Vertreter: Berg, Peter, Dipl.-Ing.
(86) Internationale Anmeldenummer: PCT/DE2000/001027
(87) Internationale Veröffentlichungsnummer: WO 2000/067542

(56) Entgegenhaltungen:
- GB-A- 2 173 426

## Beschreibung

Die Erfindung bezieht sich auf ein Verfahren zum Bestücken von Substraten mit Bauelementen.

Beim Bestücken von Substraten, insbesondere von Leiterplatten, mit Bauelementen werden die Bauelemente aus Zuführeinheiten mit Hilfe von Bestückköpfen entnommen und vom Bestückkopf auf eine vorgegebene Position auf dem Substrat positioniert. Für eine hohe Bestückleistung (bestückte Substrate pro Zeiteinheit) sollen dabei möglichst viele Bauelemente pro Zeiteinheit auf den Substraten positioniert werden.

Aus WO 98/37744 ist dafür eine Vorrichtung zum Herstellen von elektrischen Baugruppen bekannt, die in einem zentralen Bereich zwei eng benachbarte, parallel verlaufende lineare Längsführungen aufweist, in denen Wagen entsprechend verfahrbar sind. Diese Wagen weisen voneinander weg nach außen freitragende Querträger für Bestückköpfe auf. Es ergeben sich dabei zwei getrennte Bearbeitungsplätze, die unabhängig voneinander bedient werden können. Dadurch wird eine große Bestückleistung der Vorrichtung ermöglicht.

Für eine noch höhere Bestückleistung werden Bestückautomaten in einer Linie zusammengestellt. Dabei weisen die verschiedenen Bestückautomaten unterschiedliche Vorräte an Bauelementtypen auf, und können für die jeweiligen Bauelementtypen besonders ausgebildet sein. Die unterschiedlichen Bestückautomaten weisen dabei ein charakteristisches Zeitverhalten auf, welches die benötigte Zeit für das Aufnehmen der Bauelemente aus den Zuführeinheiten, den Transport zur gewünschten Position auf dem Substrat und das Absetzen der Bauelemente auf dem Substrat beinhaltet. Dieses Zeitverhalten wird in erster Näherung für alle Bestückautomaten gleichen Typs als gleich angesehen. Mit Hilfe dieses genäherten Zeitverhaltens wird ein Bestückprogramm erstellt, welches die Wege des Bestückkopfes so optimiert, daß in möglichst kurzer Zeit möglichst viele Bauelemente aufgesetzt werden können.

Diese sogenannte Rüstoptimierung berücksichtigt allerdings nicht das reale Zeitverhalten der Bestückautomaten. Dadurch kommt es zur falschen Auslastung der einzelnen Bestückplätze in der Linie. Außerdem kann es in der Bestücklinie zu nicht vorhersehbaren Unterbrechungen kommen, wie ein nicht rechtzeitig nachgerüstetes Bauelement bzw. ein durch einen Defekt ausgefallenen Förderer, einen ausgefallenen Bestückkopf oder eine ganze Station. In diesen Fällen kommt es zu einem Stillstand der ganzen Linie, obwohl nur eine Station fehlerhaft ist. Es ist die Aufgabe der Erfindung, die Bestückleistung bei der Nutzung mehrerer Bestückplätze zu erhöhen.

Die Aufgabe wird erfindungsgemäß durch ein Verfahren mit den Merkmalen des Anspruchs 1 gelöst.

Durch das erfindungsgemäße Verfahren wird das Bestückprogramm während des Betriebs überwacht, und beim Auftreten von Engpässen wird ein verbessertes Bestückprogramm genutzt. Durch die ständige Abstimmung des Bestückprogramms auf das reale Zeitverhalten der Bestückköpfe wird sowohl das reale Zeitverhalten der Maschine berücksichtigt, als auch beim Auftreten von unvorhergesehenen Fehlern ein Notbetrieb der Linie ermöglicht.

Bei der Ausführung des Verfahrens nach Anspruch 2 wird dabei das ermittelte Bestückprogramm erneut überprüft, in dem die tatsächlich für den Bestückprozeß benötigte Zeit gemessen wird. Dadurch wird überprüft, ob die zunächst nur theoretisch ermittelte Leistungsverbesserung auch tatsächlich erzielt wird. Bei starker Abweichung des theoretischen vom realen Verhalten der Bestückköpfe läßt sich somit vermeiden, daß durch das Ziel einer Verkürzung der Zeit diese in Wirklichkeit immer länger wird.

In vorteilhafter Weise wird gemäß dem Verfahren nach Anspruch 3 das reale Zeitverhalten der Bestückplätze mit dem theoretisch vorgegebenen Modell verglichen. Weicht das reale Zeitverhalten vom theoretischen Zeitverhalten ab, so wird ein verbessertes Programm unter Berücksichtigung des realen Zeitverhaltens ermittelt und für die nächsten Bestückprozesse eingesetzt.

Das Verfahren läßt sich sowohl gemäß Anspruch 4 für Bestückautomaten einsetzen, in denen mindestens zwei Bestückplätze vorgesehen sind, als auch nach Anspruch 5 in Linien, in denen mehrere Bestückautomaten hintereinander aufgestellt sind.

Zur Überprüfung, welche Bauelemente durch welche Maschine aufgesetzt wurden, ist in vorteilhafter Weise gemäß Anspruch 6 vorgesehen, daß eine Information über die an den jeweiligen Bestückplätzen aufgesetzten Bauelemente auf dem Substrat abgespeichert wird.

Durch die Anzeige einer Information für einen Bediener gemäß Anspruch 8 wird in vorteilhafter Weise sichergestellt, daß Leistungsverbesserungen, die durch Umrüsten von Zuführeinheiten entstehen, auch realisiert werden.

Anhand der in den Figuren der Zeichnung dargestellten Ausführungsbeispiele wird die Erfindung näher erläutert.

Dabei zeigen
Figur 1 eine schematische Draufsicht auf eine Linie aus drei Bestückautomaten mit jeweils zwei Bestückplätzen,
Figur 2 die Regelkreise für die Anordnung gemäß Figur 1 und
Figur 3 ein Struktogramm für den Ablauf des Verfahrens.

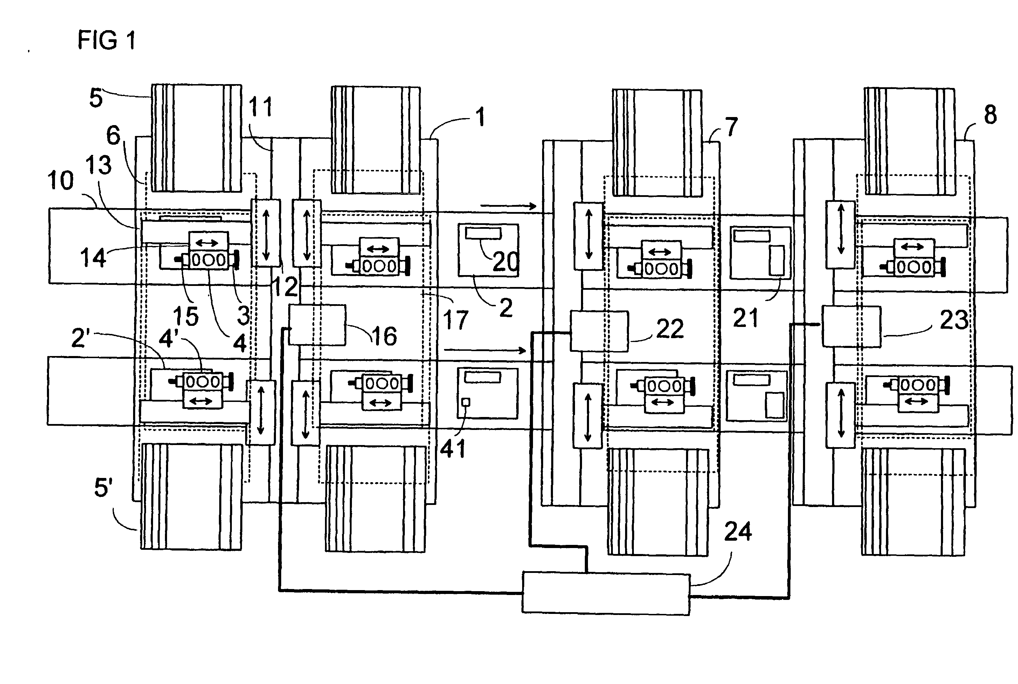

In Figur 1 ist schematisch eine Draufsicht auf eine Linie aus drei Bestückautomaten 1, 7, 8 dargestellt, wobei die einzelnen Bestückautomaten 1, 7, 8 jeweils zwei Bestückplätze 6, 17 aufweisen. Die Funktionsweise der Bestückautomaten 1, 7, 8 wird dabei exemplarisch anhand des am weitesten links stehenden ersten Bestückautomaten 1 dargestellt. Die Funktionsweise der weiteren Bestückautomaten ist entsprechend. Mit Hilfe des ersten Bestückautomaten 1 wird ein Substrat 2, insbesondere eine Leiterplatte, mit Bauelementen 3 bestückt. Dafür entnimmt ein Bestückkopf 6 die Bauelemente 3 aus einer Zuführeinheit 5, bewegt die Bauelemente 3 in die Aufsetzposition oberhalb des Substrats 2 und setzt die Bauelemente 3 in der vorgegebenen Position auf dem Substrat 2 ab. In Figur 1 ist dabei exemplarisch als Bestückkopf 4 ein sogenannter Revolverkopf dargestellt, der entlang seines Umfangs eine Anzahl Saugpipetten 15 aufweist, die mittels eines Vakuums die Bauelemente 3 am Bestückkopf 4 halten.

Zur Bewegung des Bestückkopfes 4 parallel zur Fläche des Substrats 2 sind dabei eine erste Schiene 11, an der sich ein erster Schlitten 12 bewegt, sowie eine am ersten Schlitten 12 befestigte zweite Schiene 13, an der sich ein zweiter Schlitten 14 bewegt, vorgesehen. Mit dem zweiten Schlitten 14 ist der Bestückkopf 4 verbunden, der somit jede Position auf dem Substrat 2 sowie die Positionen der Zuführeinheiten 5 erreichen kann. Dieser vom Bestückkopf 4 erreichbare Bereich wird im folgenden als erster Bestückplatz 6 bezeichnet.

Gesteuert wird die Bewegung des Bestückkopfes 4 über eine erste Kontrolleinheit 16. Ferner ist am ersten Bestückautomaten 1 ein zweiter Bestückplatz 17 mit genau dem gleichen Aufbau vorgesehen, damit zwei Substrate 2 parallel bearbeitet werden können. Dabei können sowohl zwei Substrate 2 identisch bestückt werden, um anschließend weitertransportiert zu werden, es ist aber auch vorgesehen, daß die Substrate 2 beide Bestückplätze 6,17 durchlaufen und dabei mit in der Regel unterschiedlichen Bauelementen 3 bestückt werden. Nachdem mit Hilfe des ersten Bestückautomaten 1 ein gewisses Bauelementespektrum, beispielsweise in einem ersten bestückten Substratgebiet 20 aufgesetzt wurden, wird das Substrat 2 durch eine Transportvorrichtung 10 nach rechts zum zweiten Bestückautomaten 7 weitertransportiert. Dort ist ein weiterer Bestückplatz vorgesehen, in dem nun beispielsweise ein zweites Substratgebiet 21 bestückt wird. Der zweite Bestückautomat 7 wird dabei durch eine zweite Kontrolleinheit 22 geregelt. Zusätzlich ist ein dritter Bestückautomat 8 mit einer dritten Kontrolleinheit 23 dargestellt, dessen Funktionsweise entsprechend ist. Die erste Kontrolleinheit 16, die zweite Kontrolleinheit 22 und die dritte Kontrolleinheit 23 sind mit einer Linienkontrolleinheit 24 verbunden. Natürlich können weitere Bestückautomaten in der Linie vorgesehen sein. Des weiteren können auch Bestückautomaten vorgesehen sein, die beispielsweise anstelle des Revolverkopfs andere Bestückköpfe umfassen, die beispielsweise nur eine Saugpipette 15 aufweisen. In Figur 1 sind dabei Bestückautomaten 1,7,8 dargestellt, die gleichzeitig auf zwei benachbart angeordnete Transporteinrichtungen 10 arbeiten können, wodurch bei minimalem Platzbedarf möglichst viele Substrate 2 gleichzeitig bearbeitet werden.

Zusätzlich ist der Bestückbereich 6 des Bestückkopfes 4 bis auf das Substrat 2' erstreckt, welches sich auf der zweiten Transporteinrichtung befindet. Dadurch kann der Bestückkopf 4 das dort befindliche Substrat 2' mit Bauelementen aus der Zuführeinrichtung 5' bestücken, während der weitere Bestückkopf 4' Bauelemente aus den weiteren Zuführeinrichtungen 5' aufnimmt. In diesem Fall ist das erfindungsgemäße Verfahren für die Ermittlung der Bestückplätze auf die beiden Bestückplätze des Bestückkopfes 4 und des weiteren Bestückkopfes 4' anwendbar.

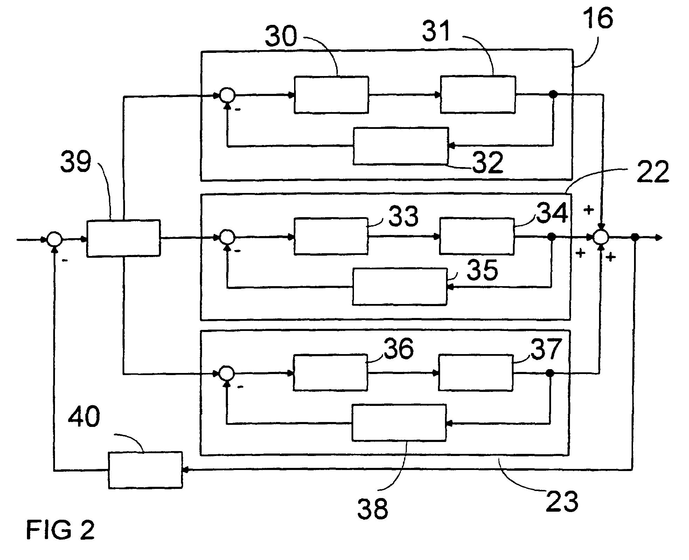

In Figur 2 sind die Regelkreise der Anordnung nach Figur 1 dargestellt. Dabei weisen die erste Kontrolleinheit 16, die zweite Kontrolleinheit 22 und die dritte Kontrolleinheit 23 jeweils einen Regler 30, 33, 36, eine Regelstrecke 31, 34, 37 und einen Beobachter 32, 35, 38 auf. Stellt nun beispielsweise der Beobachter 32 der ersten Kontrolleinheit fest, daß die beiden Bestückplätze 6,17 unterschiedlich stark ausgelastet sind, so wird der Regler 30 der ersten Kontrolleinheit dafür sorgen, daß an die Regelstrecke 31 ein entsprechendes Signal abgegeben wird. Dieses Signal umfaßt dabei ein verändertes Bestückprogramm, welches die zu bestückenden Bauelemente und die Bestückplätze einander zuordnet. Für die gesamte Linienleistung ist ein Beobachter der Linienkontrollheit 40 vorgesehen, der seine Informationen an einen Regler 39 der Linienkontrolleinheit weiterleitet. Dieser Regler 39 bewirkt, daß ein verbessertes Bestückprogramm genutzt wird, indem die Informationen des Beobachters 40 der Linienkontrolleinheit berücksichtigt wurden.

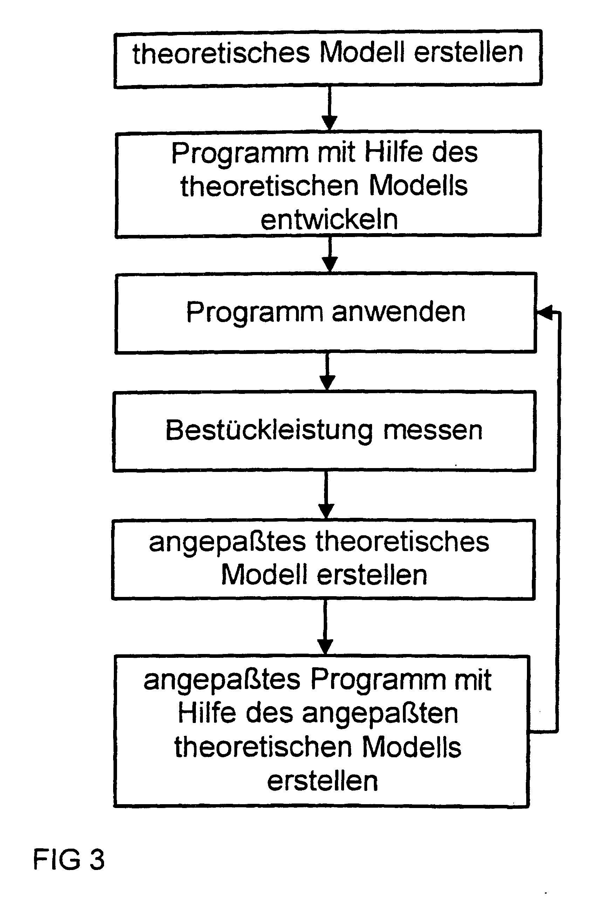

Anhand des Struktogramms der Figur 3 wird nun das erfindungsgemäße Verfahren erläutert. Dabei wird zunächst anhand des theoretischen Zeitverhaltens der Bestückautomaten 1, 7, 8 ein theoretisches Modell erstellt. Ist nun ein Substrat mit einer bestimmten Menge an Bauelementen eines bestimmten Bauelementespektrums zu bestücken, so werden die einzelnen Bauelemente, die Bauelementetypen und die einzelnen Positionen, auf denen die Bauelemente auf dem Substrat aufgesetzt werden sollen, mit Hilfe des theoretischen Modells zu einem Bestückprogramm verarbeitet, welches die unterschiedlichen Bestückplätze 6, 17 möglichst optimal nutzt, um möglichst viele Substrate 2 in möglichst kurzer Zeit zu bestücken. Dabei wird auch vorgegeben, welche Bauelemente 2 dabei in den jeweils den Bestückautomaten 1, 7, 8 zugeordneten Zuführeinheiten 5 vorrätig gehalten werden müssen.

Während dieses Programm angewendet wird, wird die Bestückleistung gemessen, die tatsächlich erzielt wird. Im allgemeinen wird das reale Zeitverhalten der Bestückautomaten 1, 7, 8 vom theoretischen Zeitverhalten abweichen. Die Abweichungen werden mit Hilfe der Beobachter 32, 35, 38, 40 ermittelt und es wird ein angepaßtes theoretisches Modell der Linie erzeugt. Dieses angepaßte theoretische Modell wird nun in der Regel auch zu einem angepaßten Bestückprogramm führen, in dem das tatsächliche Zeitverhalten der einzelnen Bestückautomaten 1, 7, 8 berücksichtigt ist. Dieses angepaßte Bestückprogramm wird nun angewendet, was zu einer höheren Bestückleistung führt. Für den Wechsel der Zuordnung zwischen zu bestückenden Bauelementen und Bestückplätzen 6, 17 ist es erforderlich, daß in den einzelnen Zuführeinheiten 5 der unterschiedlichen Bestückautomaten 1, 7, 8 die Bauelemente 3 mehrmals vorrätig sind, damit die Zuordnung gewechselt werden kann. Ist aufgrund der großen Bauelementevielfalt eine solche mehrmalige Vorratshaltung der Bauelemente 3 nicht möglich, so wird einem Bediener der Linie angezeigt werden, daß aus einer Umrüstung der Bauelemente eine erhöhte Bestückleistung resultieren würde. Der Bediener kann dann die Umrüstung von Hand vornehmen und somit ein besseres Ergebnis erzielen.

Damit für Qualitätskontrollen ("retraceability") später überprüft werden kann, welcher Bestückautomat 1, 7, 8 welche Bauelemente 3 tatsächlich bestückt hat, ist es vorgesehen, daß die einzelnen Substrate 2 Informationsspeicher 41 enthalten, in denen durch jeden einzelnen Bestückautomaten 1, 7, 8 abgespeichert wird, welche Bauelemente 3 an diesem jeweiligen Bestückautomaten bestückt wurden. Als Informationsspeicher 41 kann dabei eine autarke Speichereinheit, die drahtlos beschrieben und ausgelesen wird (ein sogenannter "TAG"), dienen.

Fällt eine Zuführeinheit 5 an einem Bestückplatz 6,17 aus, wird der Regler 39 der Linienkontrolleinheit den Bestückinhalt des über diese ausgefallene Zuführeinheit 5 ansonsten zugeführten Bauelementes 3 von einem anderen Bestückkopf 4 an einem anderen Bestückplatz 6,17 übernehmen zu lassen. Fällt ein ganzer Bestückautomat 1, 7, 8 aus, wird der gesamte Bestückinhalt dieses Bestückautomaten von einem anderen Bestückautomaten übernommen werden.

## Patentansprüche

1. Verfahren zum Bestücken von Substraten (2) mit Bauelementen (3), wobei
- die einzelnen Substrate an mindestens zwei Bestückplätzen (6,17) bestückt werden, wobei jeweils mit Hilfe von Bestückköpfen (4) die Bauelemente (3) aus Zuführeinheiten (5) entnommen und auf die den Bestückplätzen (6,17) jeweils zugeordneten Substrate (2) aufgesetzt werden,
- die Bestückköpfe (4) in Abhängigkeit von einem vorgegebenen Bestückprogramm gesteuert werden, wobei das Bestückprogramm eine Zuordnung von Bestückplätzen (6,17) und der an den jeweiligen Bestückplätzen (6,17) aufzusetzenden Bauelemente (3) umfaßt,
- während des durch das vorgegebene Bestückprogramm gesteuerten Bestückprozesses die Zeit für die Bestückung eines Substrates ermittelt wird,
- die ermittelte Zeit mit einer im vorgegebenen Bestückprogramm enthaltenen vorgegebenen Zeit verglichen und dabei eine Zeitdifferenz ermittelt wird,
- bei einer außerhalb einer vorgegebenen Zeitspanne liegenden Zeitdifferenz ein weiteres Bestückprogramm mit gegenüber dem vorgegebenen Bestückprogramm veränderter Zuordnung zwischen Bestückplätzen (6,17) und aufzusetzenden Bauelementen (3) ermittelt wird,
- der Bestückprozeß für weitere Substrate anschließend mit dem weiteren Bestückprogramm anstelle des vorgegebenen Bestückprogramms gesteuert wird.

2. Verfahren zum Bestücken von Substraten (2) mit Bauelementen (3) nach Anspruch 1,
**dadurch gekennzeichnet,**
**daß** während des durch das weitere Bestückprogramm gesteuerten Bestückprozesses die Zeit für die Bestückung eines Substrats ermittelt wird und
**daß** durch Vergleich der gemessenen Zeiten das Bestückprogramm ermittelt wird, welches die kürzere Zeit liefert, und mit diesem Bestückprogramm die Steuerung der Bestückköpfe bei zusätzlichen Substraten erfolgt.

3. Verfahren nach einem der Ansprüche 1 oder 2,
**dadurch gekennzeichnet,**
**daß** ein theoretisches Modell für die Dauer einzelner Arbeitsschritte der Bestückköpfe (4) gebildet wird,
**daß** das vorgegebene Bestückprogramm aufgrund des theoretischen Modells ermittelt wird,
**daß** bei der Messung der Zeit die reale Dauer der einzelnen Arbeitsschritte der Bestückköpfe (4) ermittelt wird,
**daß** das theoretische Modell anhand der ermittelten realen Dauer angepaßt wird,
**daß** das weitere Bestückprogramm das angepaßte theoretische Modell verwendet.

4. Verfahren zum Bestücken von Substraten (2) nach einem der Ansprüche 1, 2 oder 3,
**dadurch gekennzeichnet,**
**daß** die mindestens zwei Bestückplätze (6,17) in einer Bestückautomaten (1,7,8) vorgesehen sind.

5. Verfahren zum Bestücken von Substraten (2) nach einem der Ansprüche 1, 2 oder 3,
**dadurch gekennzeichnet,**
**daß** die mindestens zwei Bestückplätze in unterschiedlichen, in einer Linie angeordneten Bestückautomaten (1,7,8) vorgesehen sind.

6. Verfahren zum Bestücken von Substraten (2) nach einem der Ansprüche 1 bis 5,
**dadurch gekennzeichnet,**
**daß** eine Information über die an den jeweiligen Bestückplätzen (6,17) tatsächlich aufgesetzten Bauelemente (3) auf dem Substrat (2) abgespeichert wird.

7. Verfahren zum Bestücken von Substraten (2) nach einem der Ansprüche 1 bis 6,
**dadurch gekennzeichnet,**
**daß** jede Zuführeinheit (5) nur einem Bestückplatz (6,17) zugeordnet ist.

8. Verfahren zum Bestücken von Substraten nach einem der Ansprüche 1 bis 7,
**dadurch gekennzeichnet,**
**daß** eine Information für einen Bediener angezeigt wird, daß Bauelemente (3) vom einen (6) auf den zweiten Bestückplatz (17) umzurüsten sind, um die Steuerung durch das weitere Bestückprogramm zu ermöglichen.

## Claims

1. Method for mounting components (3) on substrates (2), where
- the components are mounted on the individual substrates at at least two mounting stations (6,17), where, with the aid of component mounting heads (4) the components (3) are taken in each case from feed units (5) and placed on the substrates (2) assigned to the component mounting stations (6,17),
- the component mounting heads (4) are controlled depending on a prespecified component mounting program, where the component mounting program includes assigning component mounting stations (6,17) to the components (3) to be mounted at the relevant mounting stations (6,17),
- during the mounting process controlled by the prespecified component mounting program the time for equipping a substrate is determined,
- the time determined is compared with a time contained in the prespecified component mounting program and a time difference is thus determined,
- for a time difference which lies outside a prespecified period a further component mounting program with a changed assignment between component mounting stations (6,17) and components to be mounted (3)compared to the prespecified component mounting program is determined,
- the component mounting process for further substrates is then controlled with the further component mounting program instead of the prespecified component mounting program.

2. Method for mounting components (3) on substrates (2) in accordance with Claim 1,
**characterized in that**,
during the component mounting process controlled by the further component mounting program the time for mounting components on a substrate is determined and
by comparing the measured times, the component mounting program which delivers the shorter time is determined, and this component mounting program is used to control the component mounting heads for additional substrates.

3. Method in accordance with one of the Claims 1 or 2, **characterized in that**
a theoretical model is created for the time taken for one operation by the component mounting heads (4),
the prespecified component mounting program is determined on the basis of the theoretical model,
for measuring the time, the real duration of the individual operations of the component mounting heads (4) is determined,
the theoretical model is adapted on the basis of the real duration determined,
the further component mounting program uses the adapted theoretical model.

4. Method for mounting components on substrates (2) in accordance with one of the Claims 1, 2 or 3,
**characterized in that**
the at least two component mounting stations (6,17) are provided in an automatic component mounting device (1,7, 8).

5. Method for mounting components on substrates (2) in accordance with one of the Claims 1, 2 or 3,
**characterized in that**,
the at least two component mounting stations are provided in different automatic component mounting devices (1,7,8) arranged in a line.

6. Method for mounting components on substrates (2) in accordance with one of the Claims 1 to 5,
**characterized in that**,
information is stored relating to the components (3) actually placed on the substrate (2) at the relevant component mounting stations (6,17).

7. Method for mounting components on substrates (2) in accordance with one of the Claims 1 to 6,
**characterized in that**,
each feed unit (5) is only assigned to one component mounting station (6, 17).

8. Method for mounting components on substrates in accordance with one of the Claims 1 to 7,
**characterized in that**,
information is displayed for an operator that components (3) are to be swapped from one component mounting station (6) to a second component mounting station (17), to allow control by the further component mounting program.

## Revendications

1. Procédé pour équiper des substrats (2) de composants (3)
- les substrats individuels étant équipés au niveau d'au moins deux postes d'équipement (6, 17), les composants (3) étant respectivement prélevés dans des unités d'approvisionnement (5) à l'aide de têtes d'équipement (4) et placés sur des substrats (2) respectivement associés aux postes d'équipement (6, 17),
- les têtes d'équipement (4) étant pilotées en fonction d'un programme d'équipement prédéfini, le programme d'équipement prédéfini comprenant une affectation de postes d'équipement (6, 17) à des composants (3) à placer aux postes d'équipement (6, 17) respectifs,
- au cours du processus d'équipement piloté par le programme prédéfini d'équipement, le temps nécessaire pour équiper un substrat étant déterminé,
- le temps déterminé étant comparé à un temps prédéfini contenu dans le programme d'équipement prédéfini et une différence de temps étant alors déterminée,
- dans le cas d'une différence de temps outrepassant un intervalle de temps prédéfini, un autre programme d'équipement étant déterminé ayant, par rapport au programme de placement prédéfini, une affectation modifiée entre postes d'équipement (6, 17) et composants (3) à placer,
- pour d'autres substrats, le processus d'équipement étant piloté ensuite par l'autre programme d'équipement, en remplacement du programme prédéfini d'équipement.

2. Procédé pour équiper des substrats (2) de composants (3) selon la revendication 1,
**caractérisé en ce que**
pendant le processus d'équipement piloté par l'autre programme d'équipement, le temps pour équiper un substrat est déterminé et
par comparaison des temps mesurés, le programme d'équipement fournissant la durée la plus courte est déterminé et le pilotage des têtes d'équipement pour des substrats supplémentaires se réalise à l'aide de ce programme d'équipement.

3. Procédé selon l'une quelconque des revendications 1 ou 2,
**caractérisé en ce que**
un modèle théorique est constitué pour la durée des étapes de travail individuelles des têtes d'équipement (4),
le programme prédéfini d'équipement est déterminé sur la base du modèle théorique,
lors de la mesure du temps, la durée réelle de chaque étape de travail des têtes d'équipement (4) est déterminée,
le modèle théorique est adapté à l'aide de la durée réelle déterminée,
l'autre programme d'équipement utilise le modèle théorique adapté.

4. Procédé pour équiper des substrats (2) selon l'une quelconque des revendications 1, 2 ou 3,
**caractérisé en ce que**
lesdits au moins deux postes d'équipement (6,17) sont prévus dans un automate d'équipement (1, 7, 8).

5. Procédé pour équiper des substrats (2) selon l'une quelconque des revendications 1, 2 ou 3,
**caractérisé en ce que**
lesdits au moins deux postes d'équipement (6,17) sont prévus dans différents automates d'équipement (1, 7, 8) disposés dans une chaîne.

6. Procédé pour équiper des substrats (2) selon l'une quelconque des revendications 1 à 5,
**caractérisé en ce**
**qu'**une information concernant les composants (3) effectivement placés sur le substrat (2) aux postes d'équipement respectifs (6, 17) est mémorisée.

7. Procédé pour équiper des substrats (2) selon l'une quelconque des revendications 1 à 6,
**caractérisé en ce que**
chaque unité d'approvisionnement (5) n'est affectée qu'à un seul poste d'équipement (6, 17).

8. Procédé pour équiper des substrats (2) selon l'une quelconque des revendications 1 à 7,
**caractérisé en ce qu'**une information est affichée pour un opérateur, l'informant que des composants (3) doivent être transférés d'un poste d'équipement (6) au deuxième (17), pour permettre le pilotage par l'autre programme d'équipement.
